(19) Europäisches Patentamt
European Patent Office
Office européen des brevets

(11) EP 1 684 117 A2

(12) **EUROPEAN PATENT APPLICATION**

(43) Date of publication:
**26.07.2006 Bulletin 2006/30**

(51) Int Cl.:
***G03F 7/038*** (2006.01)

(21) Application number: **06001217.6**

(22) Date of filing: **20.01.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **21.01.2005 JP 2005014242**
**28.03.2005 JP 2005091778**

(71) Applicant: **FUJI PHOTO FILM CO., LTD.**
**Minami-Ashigara-shi, Kanagawa (JP)**

(72) Inventors:
- **Kondo, Shunichi**
**Minami-Ashigara-shi**
**Kanagawa (JP)**
- **Taguchi, Yoshinori**
**Yoshida-cho**
**Haibara-gun (JP)**

(74) Representative: **HOFFMANN EITLE**
**Patent- und Rechtsanwälte**
**Arabellastrasse 4**
**81925 München (DE)**

(54) **Photosensitive lithographic printing plate**

(57) A photosensitive lithographic printing plate comprising an aluminum support and a photopolymerizable photosensitive layer containing a polymer compound including (i) a structure unit having a carbon-carbon double bond in a side chain, (ii) a structure unit having an acid group, and (iii) at least one structure unit selected from the following structure units (a) to (c): (a) a structure unit having an ethyleneoxy group, (b) a structure unit having a cyclohexyl group, and (c) a structure unit having two or more hydroxy groups.

EP 1 684 117 A2

## Description

### FIELD OF THE INVENTION

The present invention relates to a photosensitive lithographic printing plate, and particularly to a photosensitive lithographic printing plate suitable for conducting drawing with a laser beam. More specifically, it relates to a photosensitive lithographic printing plate which has high sensitivity and is suitable for high definition AM screen printing or FM screen printing of screen line number of 200 or more.

### BACKGROUND OF THE INVENTION

As an image forming method of a photopolymerizable composition by exposure, a method, which comprises forming a layer of photopolymerizable composition containing a polymer binder, an ethylenically unsaturated compound, a photopolymerization initiator, a sensitizing dye and the like on the surface of a support, exposing imagewise to polymerize and harden the ethylenically unsaturated compound in the exposed area, and then dissolving to remove the non-image area with a developing solution, thereby obtaining a hardened relief image, has been hitherto spread.

In recent years, a CTP system using image information digitalized with a computer and an Ar ion laser, an FD-YAG laser or a short wavelength semiconductor laser having an oscillation wavelength in the region of 350 to 450 nm has been developed and put into practical use.

Developments of photo initiation system of high sensitivity and high stability having responsiveness to such a laser have been actively made. Many photo initiation systems are known, for example, those described in Bruce M. Monroe et al., Chemical Reviews, 93, 435 (1993) andR.S. Davidson, Journal of Photochemistry and Photobiology A: Chemistry, 73, 81 (1993) and those described in JP-A-9-80750 (the term "JP-A" as used herein means an "unexamined published Japanese patent application"), JP-A-2001-42524 and JP-A-2000-309724.

In particular, investigations on photo initiation systems responding to a violet laser (oscillation wavelength: 405 nm) , which is expected to use as an inexpensive and compact oscillation laser in the future, have been actively made. For instance, a photo initiation system comprising a combination of an optical brightener with a lophine dimer as described in JP-A-2003-295426 and a photo initiation system comprising a combination of a short wavelength merocyanine dye with a titanocene compound as described in JP-A-2001-100412 have been reported. The development of such photo initiation systems enables preparation of a photosensitive lithographic printing plate satisfying both stability and utility sensitivity, for example, a photosensitive lithographic printing plate responding to an inexpensive violet laser. However, further increase in the sensitivity has been highly desired for the purpose of increasing productivity of printing plate.

Investigations on a polymer compound having an unsaturated group in a side chain have been made for the purpose of achieving high sensitivity and high printing durability. For instance, a binder having an allyl group in a side chain (described, for example, in JP-A-9-230594) and a binder having an acryl group in a side chain (described, for example, in JP-A-2002-182389) are enumerated.

On the other hand, printing market grows increasingly diverse and high definition printing using high line number and an FM screen has been highly required. With respect to such a requirement, since the photopolymerization reaction system is influenced by oxygen inhibiting the polymerization and after polymerization occurred in a later stage of the polymerization reaction, it is difficult to achieve reproduction of fine halftone dots and uniform halftone dot performance in a wide area. Thus, a photosensitive lithographic printing plate having sufficient performances has not been obtained. Further, a literature or patent suggesting a specific measure for the improvement is hardly found at present.

### SUMMARY OF THE INVENTION

Therefore, an object of the present invention is to provide a photosensitive lithographic printing plate which has high sensitivity, has high time-lapse stability and is excellent in halftone dot uniformity. Another object of the invention is to provide a photosensitive lithographic printing plate which is suitable for high definition AM screen printing or FM screen printing of screen line number of 200 or more.

As a result of intensive investigations to solve the problems, the inventor has found that the addition of a polymer compound having a specific structure to a photosensitive layer enables to provide a photosensitive lithographic printing plate having high sensitivity and excellent in time-lapse stability and halftone dot uniformity and to control curing property of an intermediate exposure area, thereby completing the invention.

Specifically, the objects described above can be achieved by the following items.

(1) A photosensitive lithographic printing plate comprising an aluminum support and a photopolymerizable photosensitive layer containing a polymer compound including (i) a structure unit having a carbon-carbon double bond in a side chain, (ii) a structure unit having an acid group, and (iii) at least one structure unit selected from the following

structure units (a) to (c) :

(a) a structure unit having an ethyleneoxy group,
(b) a structure unit having a cyclohexyl group, and
(c) a structure unit having two or more hydroxy groups.

(2) The photosensitive lithographic printing plate as described in (1) above, wherein the polymer compound is a polymer compound having the carbon-carbon double bond in an amount ranging from 0.2 to 2.3 mmol per g of the polymer compound and an acid value in a range of 0.5 to 2.0.
(3) The photosensitive lithographic printing plate as described in (1) or (2) above, wherein the photopolymerizable photosensitive layer further contains a photopolymerization initiator and an ethylenically unsaturated polymerizable compound.
(4) The photosensitive lithographic printing plate as described in (3) above, wherein the photopolymerization initiator is a hexaarylbisimidazole compound.
(5) The photosensitive lithographic printing plate as described in any one of (1) to (4) above, which further comprises an oxygen blocking protective layer provided on the photopolymerizable photosensitive layer.

According to the present invention, a photosensitive lithographic printing plate which has high sensitivity, has high time-lapse stability, is excellent in halftone dot uniformity, and is suitable for high definition printing use can be provided.

## DETAILED DESCRIPTION OF THE INVENTION

The photosensitive lithographic printing plate according to the invention will be described in detail below.

[Photopolymerizable photosensitive layer]

The photosensitive lithographic printing plate according to the invention is characterized by comprising a photopolymerizable photosensitive layer (hereinafter, also simply referred to as a photosensitive layer) containing a polymer compound including a structure unit having a carbon-carbon double bond in a side chain, a structure unit having an acid group, and a structure unit selected from the following structure units (a) to (c):

(a) a structure unit having an ethyleneoxy group,
(b) a structure unit having a cyclohexyl group, and
(c) a structure unit having two or more hydroxy groups.

The photosensitive lithographic printing plate enables direct recording of digital data from a computer or the like by means of exposure with an argon ion laser, an FD-YAG laser, a violet laser or the like, and formation of high definition image capable of sustaining high definition printing. Further, in order to dominantly maintain a handling property under a yellow light, which is one advantage of using the violet laser, it is necessary to control a photosensitive wavelength of photo initiation system. From this point of view, a hexaarylbisimidazole compound is effectively used as the photopolymerization initiator in the invention, because the hexaarylbisimidazole compound has an absorption wavelength in a short wavelength region and exhibits high sensitivity.
Now, the photopolymerizable photosensitive layer of the photosensitive lithographic printing plate according to the invention is sequentially described below.

<Polymer compound>

The polymer compound for use in the photosensitive layer according to the invention indispensably includes (i) a structure unit having a carbon-carbon double bond in a side chain, (ii) a structure unit having an acid group, and (iii) a structure unit of a third component having a specific structure, and may include a structure unit of other component, if desired.

< (i) Structure unit having a carbon-carbon double bond in a side chain>

The polymer compound for use in the invention is required for having at least one carbon-carbon double bond in a side chain in the structure thereof. Preferable specific embodiments of the carbon-carbon double bond structure include structures having at least one of groups represented by formulae (1) to (3) shown below.

The polymer compound includes at least one carbon-carbon double bond in the side chain thereof. The polymer compound includes at least one group having carbon-carbon double bond, for example, a group represented by any one of formulae (1) to (3) shown below, in the side chain thereof. The polymer compound may include multiple groups represented by formulae (1) to (3) or may include every one of the groups represented by formulae (1) to (3) at the same time.

The groups represented by formulae (1) to (3) are described in detail below.

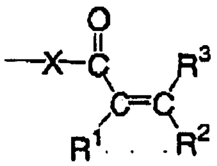
(1)

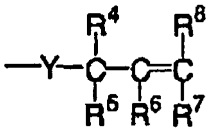
(2)

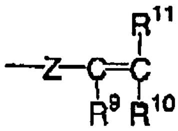
(3)

In formulae (1) to (3), $R^1$ to $R^{11}$ each independently represents a hydrogen atom or a monovalent organic group. X and Y each independently represents an oxygen atom, a sulfur atom or $-N(R^{12})-$, and $R^{12}$ represents a hydrogen atom or a monovalent organic group. Z represents an oxygen atom, a sulfur atom, $-N(R^{12})-$ or a phenylene group which may have a substituent.

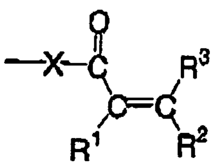
(1)

In formula (1), $R^1$ to $R^3$ each independently represents a hydrogen atom or a monovalent organic group. $R^1$ preferably includes, for example, a hydrogen atom or an alkyl group which may have a substituent. Among them, a hydrogen atom or a methyl group is preferable because of high radical reactivity. $R^2$ and $R^3$ each independently preferably includes, for example, a hydrogen atom, a halogen atom, an amino group, a carboxy group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxy group, an alkoxycarbonyl group, an alkyl group which may have a substituent or an aryl group which may have a substituent is preferable because of high radical reactivity.

X represents an oxygen atom, a sulfur atom or $-N(R^{12})-$, and $R^{12}$ represents a hydrogen atom or a monovalent organic group. The organic group represented by $R^{12}$ includes, for example, an alkyl group which may have a substituent. Among them, a hydrogen atom, a methyl group, an ethyl group or an isopropyl group is preferable because of high radical reactivity.

Examples of the substituent introduced include an alkyl group, an alkenyl group, an alkynyl group, an aryl group, an alkoxy group, an aryloxy group, a halogen atom, an amino group, an alkylamino group, an arylamino group, a carboxy group, an alkoxycarbonyl group, a sulfo group, a nitro group, a cyano group, an amido group, an alkylsulfonyl group and an arylsulfonyl group.

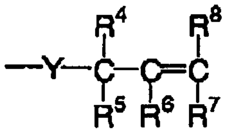

(2)

In formula (2), $R^4$ to $R^8$ each independently represents a hydrogen atom or a monovalent organic group. $R^4$ to $R^8$ each independently preferably includes, for example, a hydrogen atom, a halogen atom, an amino group, a dialkylamino group, a carboxy group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxy group, an alkoxycarbonyl group, an alkyl group which may have a substituent or an aryl group which may have a substituent is preferable.

Examples of the substituent introduced include those described in Formula (1). Y represents an oxygen atom, a sulfur atom or $-N(R^{12})-$, and $R^{12}$ has the same meaning as $R^{12}$ defined in Formula (1). Preferred examples for $R^{12}$ are also same as those described in Formula (1).

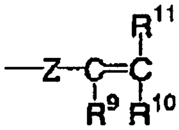

(3)

In formula (3), $R^9$ to $R^{11}$ each independently represents a hydrogen atom or a monovalent organic group. $R^9$ preferably represents a hydrogen atom or an alkyl group which may have a substituent. Among them, a hydrogen atom or a methyl group is preferable because of high radical reactivity. $R^{10}$ and $R^{11}$ each independently preferably includes, for example, a hydrogen atom, a halogen atom, an amino group, a dialkylamino group, a carboxy group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxy group, an alkoxycarbonyl group, an alkyl group which may have a substituent or an aryl group which may have a substituent is preferable because of high radical reactivity.

Examples of the substituent introduced include those described in Formula (1). Z represents an oxygen atom, a sulfur atom, $-N(R^{12})-$ or a phenylene group which may have a substituent. $R^{12}$ has the same meaning as $R^{12}$ defined in Formula (1). Preferred examples for $R^{12}$ are also same as those described in Formula (1).

It is preferred that the polymer compound includes a repeating unit represented by formula (4) shown below as the structure unit having a carbon-carbon double bond in a side chain.

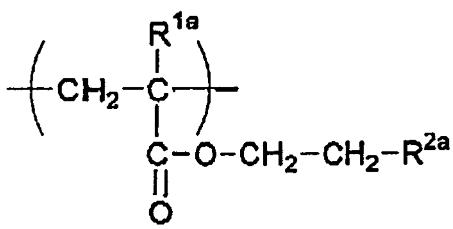

(4)

In formula (4), $R^{1a}$ represents a hydrogen atom or a methyl group, and $R^{2a}$ represents a group represented by any one of formulae (1) to (3).

The content of the repeating unit represented by formula (4) is preferably from 2 to 28% by mole, more preferably from 10 to 25% by mole, in the polymer compound.

The content of the carbon-carbon double bond in the polymer compound according to the invention is preferably in a range of 0.2 to 2.3 mmol, more preferably in a range of 0.7 to 1.5 mmol, per g of the polymer compound. By adjusting the content of the carbon-carbon double bond in the range of 0.2 to 2.3 mmol, sufficient sensitivity is obtained, preservation stability becomes good, and formation of high definition image can be achieved. The reason for achieving the formation of high definition image by adjusting the content of the carbon-carbon double bond to 2.3 mmol or less is believed to be not only that the dark polymerization in the unexposed area is inhibited but also that occurrence of unevenness due to a brush at development resulting from fringe formed around halftone dot in the case of exposing the halftone dot with a laser beam is prevented.

<(ii) Structure unit having an acid group>

It is essential that the polymer compound according to the invention includes the structure unit having an acid group in order to improve various performances, for example, removability of the non-image area. The polymer compound according to the invention preferably has an acid value raging from 0.5 to 2.0. The term "acid value" as used herein means a number of milligrams of potassium hydroxide necessary to neutralize the free fatty acid contained in one gram of the sample. The measurement of the acid value is conducted by dissolving the sample in a solvent, for example, a mixed solvent of benzene and ethanol, titrating with an aqueous potassium hydroxide solution having a precisely defined titer and being calculated from the amount for neutralization. The acid value is preferably 0.5 or more from the standpoint of sufficient removability of the non-image area to prevent residual film or the like. In particular, when heat treatment is carried out after imagewise exposure for the purpose of increasing sensitivity, the effect of preventing the occurrence of residual film is large. From the aspect of small damage in the exposed area by means of an alkali developing solution to prevent degradation of strength of image and printing durability, the acid value is preferably 2.0 or less.

The acid group includes, for example, a carboxylic acid group, a sulfonic acid group, a phosphoric acid group and a phenolic hydroxy group. The carboxylic acid group and phenolic hydroxy group are particularly preferable. A polymerizable compound having the carboxylic acid group includes, for example, acrylic acid, methacrylic acid, itaconic acid, crotonic acid, isocrotonic acid, maleic acid and p-carboxystyrene. The acrylic acid, methacrylic acid and p-carboxystyrene are particularly preferable.

A polymerizable compound having the phenolic hydroxy group includes, for example, 4-hydroxystyrene.

One kind or two or more kinds of the structure units having an acid group can be used. The content of the structure unit having an acid group is preferably from 0.1 to 50% by mole, and particularly preferably from 0.1 to 40% by mole, from the standpoint of inhibiting the damage of image strength due to the aqueous alkali development

<(iii) Structure unit of specific structure>

The structure unit of the third component, which is essential for the polymer compound according to the invention, is selected to use from (a) a structure unit having an ethyleneoxy group, (b) a structure unit having a cyclohexyl group, and (c) a structure unit having two or more hydroxy groups. The polymer compound according to the invention may include one kind of the structure units (a) to (c) or two or more kinds thereof. Also, the same kind or different kinds of two or more ethyleneoxy group, cyclohexyl group and two or more hydroxy groups, preferably two to six hydroxy groups may be present in one structure unit.

By the introduction of the structure unit of the third component into the polymer compound, compatibility of each of the components in the photosensitive composition for forming the photosensitive layer is improved, phase separation with lapse of time is prevented, and adjustment of solubility in a developing solution becomes possible, so that the effect of improving time-lapse stability can be achieved.

The content of the structure unit of the third component in total is preferably from 5 to 70% by mole, and more preferably from 10 to 50% by mole.

It is also one preferred embodiment that the polymer compound according to the invention further includes a stricture unit corresponding to other polymerizable compound in addition to the structure units (i) to (iii) described above as long as the effects of the invention are not impaired for the purpose of improving various performances, for example, the strength of image.

Examples of the polymerizable compound include polymerizable compounds selected from acrylates, methacrylates, styrenes, acrylonitrile, methacrylonitrile, acrylamides, methacrylamides and the like.

Specific examples thereof include acrylates, for example, an alkyl acrylate (preferably an alkyl acrylate having from 1 to 20 carbon atoms in the alkyl group thereof) (e.g., benzyl acrylate, 4-biphenyl acrylate, butyl acrylate, sec-butyl acrylate, tert-butyl acrylate, 4-tert-butylphenyl acrylate, 4-chlorophenyl acrylate, pentafluorophenyl acrylate, 4-cyanobenzyl acrylate, cyanomethyl acrylate, cyclohexyl acrylate, 2-ethoxyethyl acrylate, ethyl acrylate, 2-ethylhexyl acrylate,

heptyl acrylate, hexyl acrylate, isobornyl acrylate, isopropyl acrylate, methyl acrylate, 3,5-dimethyladamantyl acrylate, 2-naphthyl acrylate, neopentyl acrylate, octyl acrylate, phenethyl acrylate, phenyl acrylate, propyl acrylate, tolyl acrylate, amyl acrylate, tetrahydrofurfuryl acrylate, 2-hydroxyethyl acrylate, 3-hydroxypropyl acrylate, 2- hydroxypropyl acrylate, 4-hydroxybutyl acrylate, 5-hydroxypentyl acrylate, allyl acrylate, 2-allyoxyethyl acrylate or propagyl acrylate), methacrylates, for example, an alkyl methacrylate (preferably an alkyl methacrylate having from 1 to 20 carbon atoms in the alkyl group thereof) (e.g., benzyl methacrylate, 4-biphenyl methacrylate, butyl methacrylate, sec-butyl methacrylate, tert-butyl methacrylate, 4-tert-butylphenyl methacrylate, 4-chlorophenyl methacrylate, pentachlorophenyl methacrylate, 4-cyanophenyl methacrylate, cyanomethyl methacrylate, cyclohexyl methacrylate, 2-ethoxyethyl methacrylate, ethyl methacrylate, 2-ethylhexyl methacrylate, heptyl methacrylate, hexyl methacrylate, isobornyl methacrylate, isopropyl methacrylate, methyl methacrylate, 3,5-dimethyladamantyl methacrylate, 2-naphthyl methacrylate, neopentyl methacrylate, octyl methacrylate, phenethyl methacrylate, phenyl methacrylate, propyl methacrylate, tolyl methacrylate, amyl methacrylate, tetrahydrofurfuryl methacrylate, 2-hydroxyethyl methacrylate, 3-hydroxypropyl methacrylate, 2-hydroxypropyl methacrylate, 4-hydroxybutyl methacrylate, 5-hydroxypentyl methacrylate, allyl methacrylate, 2-allyoxyethyl methacrylate or propagyl methacrylate), styrene, styrenes, for example, an alkylstyrene (e.g., methylstyrene, dimethylstyrene, trimethylstyrene, ethylstyrene, diethylstyrene, isopropylstyrene, butylstyrene, hexylstyrene, cyclohexylstyrene, decylstyrene, benzylstyrene, chloromethylstyrene, trifluoromethylstyrene, ethoxymethylstyrene or acetoxymethylatyrene), an alkoxystyrene (e.g., methoxystyrene, 4-methoxy-3-methylstyrene or dimethoxystyrene) or a halogenostyrene (e.g., chlorostyrene, dichlorostyrene, trichlorostyrene, tetrachlorostyrene, pentachlorostyrene, bromostyrene, dibromostyrene, iodostyrene, fluorostyrene, trifluorostyrene, 2-bromo-4-trifluoromethylstyrene or 4-fluoro-3-trifluoromethylstyrene), acrylonitrile and methacrylonitrile.

Of the polymerizable compounds, acrylates, methacrylates, acrylamides, methacrylamides and styrenes are preferably used. Examples of the polymerizable compounds particularly preferably used include benzyl methacrylate, tert-butyl methacrylate, 4-tert-butylphenyl methacrylate, pentachlorophenyl methacrylate, 4-cyanophenyl methacrylate, cyclohexyl methacrylate, ethyl methacrylate, 2-ethylhexyl methacrylate, isobornylmethacrylate, isopropyl methacrylate, methyl methacrylate, 3,5-dimethyladamantyl methacrylate, 2-naphthyl methacrylate, neopentyl methacrylate, phenyl methacrylate, tetrahydrofurfuryl methacrylate, 2-hydroxyethyl methacrylate, 3-hydroxypropyl methacrylate, 2-hydroxypropyl methacrylate, allyl methacrylate, acrylamide, N-methylacrylamide, N-isopropylacrylamide, morpholylacrylamide, piperidylacrylamide, N-tert-butylacrylamide, N-cyclohexylacrylamide, N-phenylacrylamide, N-naphthylacrylamide, N-hydroxymethylacrylamide, N-hydroxyethylacrylamide, N-allylacrylamide, 4-hydroxyphenylacrylamide, 2-hydroxyphenylacrylamide, N,N-dimethylacrylamide, N,N-diisoproylacrylamide, N,N-di-tert-butylacrylamide, N,N-dicyclohexylacrylamide, N,N-diphenylacrylamide, N,N-dihydroxyethylacrylamide, N,N-diallylacrylamide, methacrylamide, N-methylmethacrylamide, N-isopropylmethacrylamide, morpholylmethacrylamide, piperidylmethacrylamide, N-tert-butylmethacrylamide, N-cyclohexylmethacrylamide, N-phenylmethacrylamide, N-naphthylmethacrylamide, N-hydroxymethylmethacrylamide, N-hydroxyethylmethacrylamide, N-allylmethacrylamide, 4 -hydroxyphenylmethacrylamide, 2-hydroxyphenylmethacrylamide, N,N-dimethylmethacrylamide, N,N-diisoproylmethacrylamide, N,N-di-tert-butylmethacrylamide, N,N-dicyclohexylmethacrylamide, N,N-diphenylmethacrylamide, N,N-dihydroxyethylmethacrylamide, N,N-diallylmethacrylamide, styrene, methylstyrene, dimethylstyrene, trimethylstyrene, isopropylstyrene, butylstyrene, cyclohexylstyrene, chloromethylstyrene, trifluoromethylstyrene, ethoxymethylstyrene, acetoxymethylstyrene, methoxystyrene, 4-methoxy-3-methylstyrene, chlorostyrene, dichlorostyrene, trichlorostyrene, tetrachlorostyrene, pentachlorostyrene, bromostyrene, dibromostyrene, iodostyrene, fluorostyrene, trifluorostyrene, 2-bromo-4-trifluoromethylstyrene and 4-fluoro-3-trifluoromethylstyrene.

These other polymerizable compounds may be used individually or as a mixture of two or more thereof. The content of such polymerizable compound is preferably from 0 to 90% by mole, particularly preferably from 0 to 60% by mole, in the polymer compound according to the invention. In the range of the content described above, good effect of hardening the layer is obtained.

The polymer compound according to the invention can be synthesized by a known method, for example, a radical polymerization method using monomers corresponding to the respective structure units.

A solvent for use in the synthesis of the polymer compound according to the invention includes, for example, ethylene dichloride, cyclohexanone, methyl ethyl ketone, acetone, methanol, ethanol, propanol, butanol, ethylene glycol monomethyl ether, ethylene glycol monoethyl ether, 2-methoxyethyl acetate, 1-methoxy-2-propanol, 1-methoxy-2-propyl acetate, N,N-dimethylformamide, N,N-dimethylacetamide, dimethylsolfoxide, toluene, ethyl acetate, methyl lactate and ethyl lactate. The solvents may be used individually or as a mixture of two or more thereof.

The polymer compound according to the invention preferably has a weight average molecular weight of 6,000 or more, and more preferably in a range of 50,000 to 200,000. The weight average molecular weight of the polymer compound is preferably 6,000 or more in view of an appropriate glass transition temperature and good strength of image, and also is preferably 200,000 or less in view of good developing property.

Further, the polymer compound according to the invention may contain an unreacted monomer. In such a case, the content of the unreacted monomer is desirably 15% by weight or less in the polymer compound.

The polymer compounds according to the invention may be used individually or as a mixture of two or more thereof. The photosensitive layer according to the invention may further contain a polymer compound other than the polymer compound according to the invention. The amount of the other polymer compound is preferably 80% by weight or less, more preferably 50% by weight or less, based on the total weight of the other polymer compound and the polymer compound according to the invention.

The amount of the polymer compound according to the invention included in the photosensitive layer of the photosensitive lithographic printing plate of the invention is preferably from 5 to 95% by weight, more preferably from 10 to 85% by weight, in terms of solid content. The amount of the polymer compound is preferably 5% by weight or more in view of excellent strength of the image area when the image is formed. The amount is also preferably 95% by weight or less in view of good image-forming property.

Specific examples of the polymer compound according to the invention include the polymer compounds shown below, but the invention should not be construed as being limited thereto.

A-1
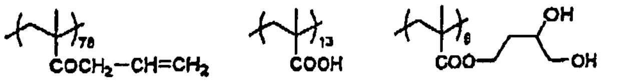
Acid value: 1.1
Molecular weight (Mw): 5.3 x $10^4$

A-2
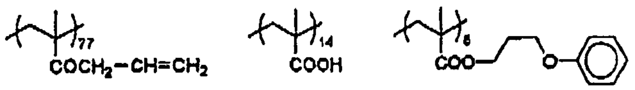
Acid value: 1.1
Molecular weight (Mw): 3.8 x $10^4$

A-3
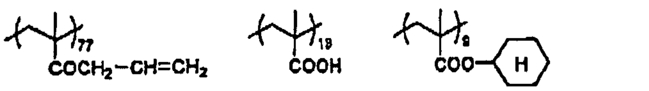
Acid value: 1.1
Molecular weight (Mw): 5.3 x $10^4$

A-4
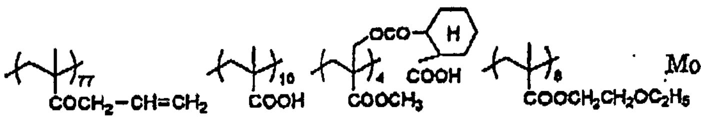
Acid value: 1.1
Molecular weight (Mw): 3.6 x $10^4$

A-5
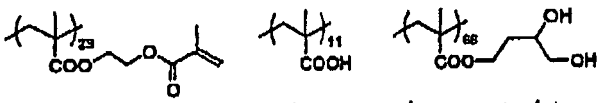
Acid value: 0.9
Molecular weight (Mw): 6 x $10^4$

A-6
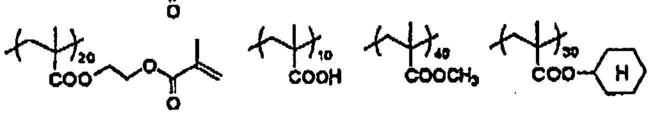
Acid value: 0.9
Molecular weight (Mw): 7.2 x $10^4$

A-7
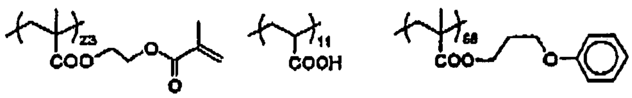
Acid value: 0.9
Molecular weight (Mw): 3.4 x $10^4$

A-8
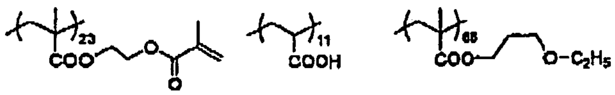
Acid value: 0.9
Molecular weight (Mw): 3.6 x $10^4$

A-9
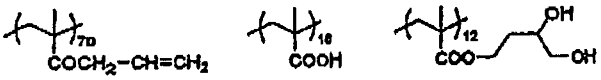
Acid value: 2.0
Molecular weight (Mw): 5.8 x $10^4$

A-10
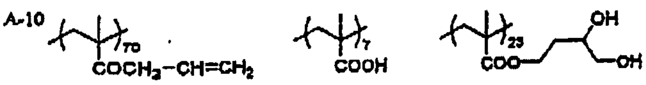
Acid value: 0.6
Molecular weight (Mw): 5.5 x $10^4$

A-11
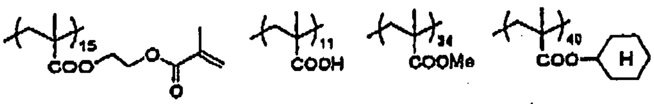
Acid value: 0.9
Molecular weight (Mw): 3.8 x $10^4$

A-12
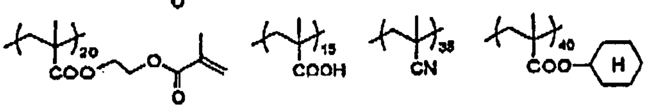
Acid value: 1.5
Molecular weight (Mw): 5.2 x $10^4$

It is preferred that the photosensitive layer of the photosensitive lithographic printing plate according to the invention contain a photopolymerization initiator and an ethylenically unsaturated polymerizable compound.

<Photopolymerization initiator>

As the photopolymerization initiator incorporated into the photosensitive layer of the photosensitive lithographic printing plate according to the invention, various photopolymerization initiators known in patents and literatures, a photo-initiation system comprising a photopolymerization initiator and a sensitizing dye (for example, dyes described hereinafter) or a combination system of two or more photopolymerization initiators (photo-initiation system) may be appropriately selected to use depending upon a wavelength of a light source employed. Specific examples thereof are illustrated below, but the invention should not be construed as being limited thereto.

Various photo-initiation systems have also been proposed for using visible light of 400 nm or longer, an Ar laser, second harmonic of a semiconductor laser or an SHG-YAG laser as the light source. For instance, there are illustrated a certain kind of photo-reductive dyes (e.g., Rose Bengale, Eosine and Erythrosine) described in U.S. Patent 2,850,445 and a system comprising a combination of a dye and an initiator, for example, a composite initiator system of a dye and an amine (JP-B-44-20189 (the term "JP-B" as used herein means an "examined Japanese patent publication")), a combined use of hexaarylbisimidazole, a radical generator and a dye (JP-B-45-37377), a system of hexaarylbisimidazole and p-dialkylaminobenzylidene ketone (JP-B-47-2528 and JP-A-54-155292), a system of a cyclic cis-$\alpha$-dicarbonyl compound and a dye (JP-A-48-84183), a system of a cyclic triazine and a merocyanine dye (JP-A-54-151024), a system of 3-ketocoumarin and an active agent (JP-A-52-112681 and JP-A-58-15503), a system of bisimidazole, a styrene derivative and thiol (JP-A-59-140203), a system of an organic peroxide and a dye (JP-A-59-1504, JP-A-59-140203, JP-A-59-189340, JP-A-62-174203, JP-B-62-1641 and U.S. Patent 4,766,055), a system of a dye and an active halogen compound (JP-A-63-258903 and JP-A-2-63054), a system of a dye and a borate compound (JP-A-62-143044, JP-A-62-150242, JP-A-64-13140, JP-A-64-13141, JP-A-64-13142, JP-A-64-13143, JP-A-64-13144, JP-A-64-17048, JP-A-1-229003, JP-A-1-298348 and JP-A-1-138204), a system of a rhodanine ring-containing dye and a radical generator (JP-A-2-179643 and JP-A-2-244050), a system of titanocene and a 3-ketocoumarin dye (JP-A-63-221110), a system wherein titanocene is combined with a xanthene dye and, further, an amino group- or urethane group-containing addition-polymerizable ethylenically unsaturated bond-containing compound (JP-A-4-221958 and JP-A-4-219756), a system of titanocene and a specific merocyanine dye (JP-A-6-295061) and a system of titanocene and a benzopyran ring-containing dye (JP-A-8-334897).

Recently, a laser emitting light having a wavelength of 400 to 410 nm (violet laser) has been developed, and a photo-initiation system showing a high sensitivity to light having a wavelength of 450 nm or less has been developed. Such a photo-initiation system can also be employed. Examples thereof include a cation dye/borate system (JP-A-11-84647), a merocyanine dye/titanocene system (JP-A-2000-147763), a carbazole type dye/titanocene system (JP-A-2001-42524), an optical brightener/hexaarylbisimidazole system (2003-295426), and an oxazole dye/hexaarylbisimidazole system (WO 2004/074930). In the invention, a system using a hexaarylbisimidazole compound is particularly preferred because the system is excellent in sensitivity and photosensitive wavelength.

As the hexaarylbisimidazole compound, various compounds described, for example, in European Patents 24,629 and 107,792, U.S. Patent 4,410,621, European Patent 215,453 and German Patent 3,211,312 can be used.

Preferred examples of the hexaarylbisimidazole compound include 2, 4, 5, 2', 4', 5'-hexaphenylbisimidazole, 2,2'-bis(2-chlorophenyl)-4, 5, 4',5'-tetraphenylbisimidazole, 2,2'-bis(2-bromophenyl)-4, 5, 4',5'-tetraphenylbisimidazole, 2,2'-bis(2,4-dichlorophenyl)-4,4',5,5'-tetraphenylbisimidaz ole, 2,2' -bis (2-chlorophenyl) -4, 5, 4',5'-tetrakis(3-methoxyphenyl)bisimidazole, 2,5,2' ,5' -tetrakis(2-chlorophenyl) -4,4'-bis (3,4-dimethoxyph enyl)bisimidazole, 2,2'-bis(2,6-dichlorophenyl)-4, 5, 4',5'-tetraphenylbisimidazole,2,2'-bis(2-nitrophenyl)-4,5, 4',5'-tetraphenylbisimidazole,2,2'-di-o-tolyl-4, 5, 4',5'-tetraphenylbisimidazole,2,2'-bis(2-ethoxyphenyl)-4,5, 4',5'-tetraphenylbisimidazole and 2,2' -bis (2,6-difluorophenyl) -4, 5, 4',5'-tetraphenylbisimidazole.

The photo-initiation ability is moreover enhanced by adding to the above-described photopolymerization initiator, as a so-called co-sensitizer, a hydrogen-providing compound, for example, a thiol compound (e.g., 2-mercaptobenzothiazole, 2-mercaptobenzimidazole or 2-mercaptobenzoxazole) or an amine compound (e.g., N-phenyglycine or N,N-dialkylamino aromatic alkyl ester), if desired. The thiol compound is preferred as the co-sensitizer.

The amount of the photopolymerization initiator (system) used is in a range from 0.05 to 100 parts by weight, preferably from 0.1 to 70 parts by weight, still more preferably from 0.2 to 50 parts by weight, based on 100 parts by weight of the ethylenically unsaturated polymerizable compound.

<Ethylenically unsaturated polymerizable compound>

The ethylenically unsaturated polymerizable compound is a compound having an ethylenically unsaturated bond, which is addition-polymerized by the action of a polymerization initiator to crosslink or harden, when it is irradiated with active radiation. The compound having an addition-polymerizable ethylenically unsaturated bond can be appropriately selected from compounds having at least one, preferably two or more terminal ethylenically unsaturated bonds. The compound has a chemical form, for example, a monomer, a prepolymer (i.e., dimmer, trimer or oligomer), a copolymer

thereof, or a mixture thereof.

Examples of the monomer include esters between an unsaturated carboxylic acid (for example, acrylic acid, methacrylic acid, itaconic acid, crotonic acid, isocrotonic acid or maleic acid) and an aliphatic polyhydric alcohol compound and amides between an unsaturated carboxylic acid and an aliphatic polyamine compound.

Specific examples of the monomer of the ester between an aliphatic polyhydric alcohol compound and an unsaturated carboxylic acid include acrylates, for example, ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol pentaacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate or polyester acrylate oligomer;

methacrylates, for example, tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethaerylate, dipentaerythritol dimethacrylate, dipentaerythritol hexamethacrylate, dipentaerythritol pentamethacrylate, sorbitol trimethacrylate, sorbitol tetramethacrylate, bis[p-(3-mathacryloxy-2-hydroxypropoxy)phenyl] dimethylmetha ne or bis-[p-(methacryloxyethoxy)phenyl]dimethylmethane; itaconates, for example, ethylene glydcol diitaconate, propylene glycol diitaconate, 1,5-butanediol diitaconate, 1,4-butanediol diitaconate, tetramethylene glycol diitaconate, pentaerythritol diitaconate or sorbitol tetraitaconate; crotonatates, for example, ethylene glycol dicrotonate tetramethylene glycol dicrotonate, pentaerythritol dicrotonate or sorbitol tetradicrotonate;

isocrotonates, for example, ethylene glycol diisocrotonate, pentaerythritol diisocrotonate or sorbitol tetraisocrotonate; and maleates, for example, ethylene glycol dimaleate, triethylene glycol dimaleate, pentaerythritol dimaleate or sorbitol tetramaleate. Further, mixtures of the ester monomers are exemplified.

Also, specific examples of the monomer of the amide between an aliphatic polyamine compound and an unsaturated carboxylic acid include methylenebisacrylamide, methylenebismethacrylamide, 1,6-hexamethylenebisacrylamide, 1,6-hexamethylenebismethacrylamide, diethylenetriaminetrisacrylamide, xylylenebisacrylamide and xylylenebismethacrylamide,

In addition, vinylurethane compounds having two or more polymerizable vinyl groups per molecule described in JP-B-48-41708, which are obtained by adding a hydroxy group-containing vinyl monomer represented by formula (A) shown below to a polyisocyanate compound having two or more isocyanate groups per molecule.

$$CH_2=C(R)COOCH_2CH(R')OH \qquad (A)$$

wherein R and R' each independently represents a hydrogen atom or $-CH_3$.

Also, urethane acrylates described in JP-A-51-37193 and JP-B-2-32293, polyester acrylates described in JP-A-48-64183, JP-B-49-43191 and JP-B-52-30490, and polyfunctional acrylates or methacrylates, for example, epoxyacrylates obtained by reacting an epoxy resin with (meth) acrylic acid are set forth. Further, photo-curable monomers and oligomers described in Nippon Secchaku Kyokaishi, Vol. 20, No.7, pages 300 to 308 (1984) may be used.

The amount of the ethylenically unsaturated polymerizable compound used is preferably in a range from 5 to 80% by weight, more preferably from 30 to 70% by weight, based on the total component constituting the photopolymerizable photosensitive layer.

In the photopolymerizable photosensitive layer of the photosensitive lithographic printing plate according to the invention, various compounds, for example, a thermal polymerization inhibitor, a coloring agent or a plasticizer, can be used together in addition to the above-described components, if desired.

In the invention, it is preferred to add a small amount of a thermal polymerization inhibitor in addition to the above-described basic components, in order to prevent the ethylenically unsaturated polymerizable compound from undergoing undesirable thermal polymerization during the production or preservation of the photosensitive composition (hereinafter also referred to as "photopolymerizable composition" or simply "composition") for forming the photopolymerizable photosensitive layer. Suitable examples of the thermal polymerization inhibitor include hydroquinone, p-methoxyphenol, di-tert-butyl-p-cresol, pyrogallol, tert-butylcatechol, benzoquinone, 4,4-thiobis (3-methyl-6-tert-butylphenol), 2,2'-methylenebis(4-methyl-6-tert-butylphenol), N-nitrosophenylhydroxyamine cerium (III) salt and N-nitrosophenylhydroxylamine aluminum salt. The amount of the thermal polymerization inhibitor added is preferably from about 0.01 to about 5% by weight, based on the total weight of the composition. If desired, in order to prevent polymerization inhibition due to oxygen, a higher fatty acid derivative, for example, behenic acid or behenic amide may be added and allowed to localize on the surface of the photopolymerizable photosensitive layer during the drying step after the coating thereof. The amount of the higher fatty acid derivative added is preferably from about 0.5 to about 10% by weight based on the total weight of the composition.

Further, for the purpose of coloring the photopolymerizable photosensitive layer, a coloring agent may be added. Examples of the coloring agent include phthalocyanine pigments (for example, C.I. Pigment Blue 15:3, C.I. Pigment Blue 15:4 or C. I. Pigment Blue 15: 6), azo pigments, pigments, for example, carbon black or titanium oxide, Ethyl Violet, Crystal Violet, azo dyes, anthraquinone dyes and cyanine dyes. The amount of the dye or pigment added is preferably from about 0.5 to about 20% by weight of the total weight of the composition. In addition, for the purpose of improving physical properties of the cured film, an additive, for example, an inorganic filler or a plasticizer (for example, dioctyl phthalate, dimethyl phthalate or tricresyl phosphate) may be added. The amount of the additive added is preferably 10% by weight or less of the total weight of the composition.

The photosensitive layer of the photosensitive lithographic printing plate according to the invention is ordinarily formed by dissolving the above-described photosensitive composition in a solvent and coating the resulting solution on a support described hereinafter, followed by drying. Examples of the solvent used include acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxymethoxyethanol, diethylene glycol monomethyl ether, diethylene glycol monoethyl ether, diethylene glycol dimethyl ether, diethylene glycol diethyl ether, propylene glycol monomethyl ether acetate, propyolene glycol monoethyl ether acetate, 3-methoxypropyl acetate, N,N-dimethylformamide, dimethylsulfoxide, γ-butyrolactone, methyl lactate and ethyl lactate. The solvents may be used individually or as a mixture thereof. The concentration of solid content in the coating solution is appropriately from 1 to 50% by weight.

A surfactant may be added to the photopolymerizable composition for the photopolymerizable photosensitive layer of the photosensitive lithographic printing plate according to the invention in order to improve surface quality of coating.

The coverage of the photopolymerizable photosensitive layer is appropriately in a range from about 0.1 to about 10 $g/m^2$, preferably from 0.3 to 5 $g/m^2$, and more preferably from 0.5 to 3 $g/m^2$, in terms of weight after drying.

On the photopolymerizable photosensitive layer described above, it is preferred to provide an oxygen blocking protective layer in order to avoid polymerization inhibiting function of oxygen. The oxygen blocking protective layer ordinarily contains a water-soluble vinyl polymer. Examples of the water-soluble vinyl polymer included in the oxygen blocking protective layer include polyvinyl alcohol, a partial ester, ether or acetal thereof and a copolymer thereof containing a substantial amount of an unsubstituted vinyl alcohol unit necessary for providing the water-solubility. Examples of the polyvinyl alcohol include those having a hydrolysis ratio of 71 to 100% and a polymerization degree in a range of 300 to 2,400. Specifically, PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8, all of which are manufactured by Kuraray Co., Ltd., are enumerated. The copolymer includes polyvinyl acetate chloroacetate or propionate, polyvinyl formal and polyvinyl acetal hydrolyzed to an extent of 88 to 100% and copolymers thereof. Other useful polymers include, for example, polyvinyl pyrrolidone, gelatin and gum arabic. The polymers may be used individually or in combination.

As a solvent used for coating the oxygen blocking protective layer in the photosensitive lithographic printing plate according to the invention, though pure water is preferable, a mixture of pure water with an alcohol, for example, methanol or ethanol or a ketone, for example, acetone or methyl ethyl ketone may be used. The concentration of the solid content in the coating solution is appropriately from 1 to 20% by weight. To the oxygen blocking protective layer may be added known additives, for example, a surfactant for improving coating property or a water-soluble plasticizer for improving physical property of the coated layer. Examples of the water-soluble plasticizer include propionamide, cyclohexanediol, glycerin and sorbitol. Also, a water-soluble (meth)acrylic polymer may be added.

The coverage of the oxygen blocking protective layer is preferably from about 0.1 to about 15 $g/m^2$, more preferably from about 1.0 to about 5 $g/m^2$, in terms of weight after drying.

(Aluminum support)

Now, an aluminum support of the photosensitive lithographic printing plate according to the invention is described in detail below. The aluminum support for use in the invention includes a dimensionally stable aluminum or aluminum alloy (for example, alloy of aluminum with silicon, copper, manganese, magnesium, chromium, zinc, lead, bismuth or nickel) plate, and plastic film or paper laminated or deposited with aluminum or aluminum alloy. The thickness of the support is ordinarily from about 0.05 to about 1 mm. A composite sheet described in JP-A-48-18327 is also used.

Surface roughness (Ra) of the aluminum support according to the invention is preferably from 0.2 to 0.55 μm. In order to obtain such surface roughness, the aluminum support is ordinarily subjected to surface treatments described hereinafter. The term "surface roughness" of the aluminum support as used herein means center line average roughness (arithmetic average roughness) (Ra) in the direction perpendicular to the rolling direction of aluminum and it is determined

in the following manner. A section having a measure length of L is sampled from a roughness curve determined by a stylus-type measuring instrument in the direction of center line thereof and when a roughness is represented by formula Y=f(X) in the coordinates in which the direction of the center line of the sampled section is set as the X-axis and the direction perpendicular to the X-axis is set as the Y-axis, a value represented by an equation shown below in terms of μm is the center line average roughness. The determination of measure length of L and the measurement of average roughness are conducted according to JIS B 0601.

$$Ra = \frac{1}{L}\int_0^L |f(X)|\,dX$$

<Graining Treatment>

A method for the graining treatment used includes a mechanical graining method, a chemical graining method and an electrolytic graining method as described in JP-A-56-28893. Specifically, an electrochemical graining method wherein surface graining is electrochemically conducted in an electrolytic solution of hydrochloric acid or nitric acid, and a mechanical graining method, for example, a wire brush graining method wherein a surface of aluminum plate is scratched with a wire brush, a ball graining method wherein a surface of aluminum plate is grained with abrasive balls and an abrasive or a brush graining method wherein a surface of aluminum plate is grained with a nylon brush and an abrasive may also be employed. The graining methods may be used individually or in combination of two or more thereof. Of these methods, the electrochemical graining method wherein surface graining is electrochemically conducted in an electrolytic solution of hydrochloric acid or nitric acid is preferred. The current density suitable for use is in a range from 100 to 400 Coulomb/$dm^2$. More specifically, it is preferred to perform electrolysis in an electrolytic solution containing from 0.1 to 50% by weight of hydrochloric acid or nitric acid under the conditions of a temperature from 20 to 100°C, a period from one second to 30 minutes and a current density from 100 to 400 Coulomb/$dm^2$.

The aluminum support subjected to the surface graining treatment is then chemically etched with an acid or an alkali. The method of using an acid as an etching agent takes time for destroying fine structures and thus, it is disadvantageous to industrially apply the method to the invention. Such disadvantage can be overcome by using an alkali as the etching agent.

Examples of the alkali agent preferably used in the invention include sodium hydroxide, sodium carbonate, sodium aluminate, sodium metasilicate, sodium phosphate, potassium hydroxide and lithium hydroxide. Preferred ranges of concentration and temperature are form 1 to 50% by weight and 20 to 100°C, respectively. The alkali etching is preferably performed so that a dissolution amount of aluminum is in a range from 5 to 20 g/$m^3$.

After the etching procedure, the support is subjected to washing with an acid for removing stain (smut) remaining on the surface thereof. Examples of the acid for use in the acid-washing step include nitric acid, sulfuric acid, phosphoric acid, chromic acid, hydrofluoric acid and borofluoric acid. As the method for removing smut after the electrochemical graining treatment, a method of bringing the aluminum support into contact with a 15 to 65% by weight aqueous solution of sulfuric acid having a temperature of 50 to 90°C as described in JP-A-53-12739 and a method of performing alkali etching as described in JP-B-48-28123 are preferred.

<Anodizing Treatment>

The aluminum support thus-treated is then preferably subjected to anodizing treatment. The anodizing treatment can be conducted in a manner conventionally used in the field of art. Specifically, it is performed by applying a direct current or alternating current to the aluminum support in an aqueous solution or non-aqueous solution containing sulfuric acid, phosphoric acid, chromic acid, oxalic acid, sulfamic acid, benzenesulfonic acid, or a combination of two or more thereof to form an anodic oxide layer on the surface of aluminum support.

The conditions of anodizing treatment cannot be determined generally, since they vary widely depending on an electrolytic solution to be used. However, ordinarily, a concentration of the electrolytic solution is in a range from 1 to 80%, a temperature of the electrolytic solution is in a range from 5 to 70°C, a current density is in a range from 0.5 to 60 Ampere/$dm^2$, a voltage is in a range from 1 to 100 v, and a period of electrolysis is in a range from 10 to 100 seconds.

Of the anodizing treatments, a method of anodizing in a sulfuric acid solution with a high current density described in British Patent 1,412,768 and a method of anodizing using phosphoric acid as an electrolytic bath described in U.S. Patent 3,511,661 are preferably used.

In the invention, the thickness of anodic oxide layer is preferably from 1 to 10 g/$m^2$. When the thickness is more than 1 g/$m^2$, the printing plate is prevented from scratching. When the thickness is less than 10 g/$m^2$, a large quantity of electric power is unnecessary and thus it is economically advantageous. The thickness of anodic oxide layer is more

preferably from 1.5 to 7 $g/m^2$, and still more preferably from 2 to 5 $g/m^2$.

In the invention, the aluminum support may further be subjected to a sealing treatment of the anodic oxide layer after the graining treatment and anodizing treatment. The sealing treatment is performed by immersing the aluminum support in hot water or a hot aqueous solution containing an inorganic salt or an organic salt, or transporting in a water vapor bath. Moreover, the aluminum support according to the invention may be subjected to a surface treatment, for example, silicate treatment with an alkali metal silicate or immersion in an aqueous solution of potassium fluorozirconate or a phosphate.

On the aluminum support subjected to the surface treatment as described above, the photopolymerizable photosensitive layer comprising the photopolymerizable composition described above is coated to prepare the photosensitive lithographic printing plate according to the invention. Prior to the coating of photosensitive layer, an organic or inorganic undercoat layer (intermediate layer) may be provided on the support, if desired.

A method for making a lithographic printing plate using the photosensitive lithographic printing plate of the invention is described in detail below. The above-described photosensitive lithographic printing plate is imagewise exposed and then developed preferably with an alkali aqueous solution. The developing solution used for the plate-making method of the invention is described below.

[Developing solution]

The developing solution used for the plate-making method of the photosensitive lithographic printing plate according to the invention is not particularly limited but, for example, a solution containing an inorganic alkali salt and a surfactant and having a pH of 11.0 to 12.7 is preferably used.

The inorganic alkali salt is appropriately used. Examples thereof include an inorganic alkali agent, for example, sodium hydroxide, potassium hydroxide, ammonium hydroxide, lithium hydroxide; sodium silicate, potassium silicate, ammonium silicate, lithium silicate, sodium tertiary phosphate, potassium tertiary phosphate, ammonium tertiary phosphate, sodium carbonate, potassium carbonate, ammonium carbonate, sodium hydrogencarbonate, potassium hydrogencarbonate, ammonium hydrogencarbonate, sodium borate, potassium borate and ammonium borate. The inorganic alkali salts may be used independently or in combination of two or more thereof.

In the case of using a silicate, developing property can be easily adjusted by selecting a mixing ratio of silicon oxide ($SiO_2$) to alkali oxide ($M_2O$ (wherein M represents an alkali metal or an ammonium group)), which are components of the silicate, and the concentration thereof. Of the alkali aqueous solutions, an alkali aqueous solution having the mixing ratio of silicon oxide to alkali oxide ($M_2O$) ($SiO_2/M_2O$ in molar ratio) of 0.5 to 3.0 is preferred, and that of 1.0 to 2.0 is more preferred The concentration of the silicate in the alkali aqueous solution is preferably from 1 to 10% by weight, more preferably from 3 to 8% by weight, particularly preferably from 4 to 7% by weight. When the concentration is in the above-described range, there arise no reduction in developing property and processing ability, no formation of precipitates and crystals, and no gelation at neutralization of waste liquor of the developing solution, thereby causing no troubles in treatment of the waste liquor.

Also, an organic alkali agent may be supplementarily used for the purpose of delicate adjustment of alkali concentration and assisting dissolution of the photosensitive layer. The organic alkali agent includes monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine and tetramethylammonium hydroxide. The organic alkali agents may be used independently or in combination of two or more thereof.

The surfactant is appropriately used. Examples thereof include nonionic surfactants, for example, a nonionic surfactant having polyoxyalkylene ether group, a polyoxyethylene alkyl ester (e.g., polyoxyethylene stearate), a sorbitan alkyl ester (e.g., sorbitan monolaurate, sorbitan monostearate, sorbitan distearate, sorbitan monooleate, sorbitan sesquioleate or sorbitan trioleate) and a monoglyceride alkyl ester (e.g., glycerol monostearate or glyceron monooleate); anionic surfactants, for example, an alkylbenzenesulfonate (e.g., sodium dodecylbenzenesulfonate) an alkylnaphthalenesulfonate (e.g., sodium butylnaphthalenesulfonate, sodium pentylnaphthalenesulfonate sodium hexylnaphthalenesulfonate or sodium octylnaphthalenesulfonate), an alkylsulfate (e.g., sodium laurylsulfate), an alkylsulfonate (e.g., sodium dodecylsulfonate) and a sulfosuccinic acid ester salt (e.g., sodium dilaurylsulfosuccinate); and amphoteric surfactants, for example, an alkylbetaine (e.g., laurylbetaine or stearylbetaine) and an amino acid. Nonionic surfactants having a polyoxyalkylene ether group are particularly preferred.

As the surfactant having a polyoxyalkylene ether group, a compound having the structure represented by formula (I) shown below is preferably used.

$$R^{40}\text{-O-}(R^{41}\text{-O})_pH \qquad (I)$$

wherein $R^{40}$ represents an alkyl group having from 3 to 15 carbon atoms, which may have a substituent, an aromatic

hydrocarbon group having from 6 to 15 carbon atoms, which may have a substituent or a heteroaromatic cyclic group having from 4 to 15 carbon atoms, which may have a substituent. Examples of the substituent include an alkyl group having from 1 to 20 carbon atoms, a halogen atom, e.g., Br, Cl or I, an aromatic hydrocarbon group having from 6 to 15 carbon atoms, an aralkyl group containing 7 to 17 carbon atoms, an alkoxy group having from 1 to 20 carbon atoms, an alkoxycarbonyl group having from 2 to 20 carbon atoms and an acyl group having from 2 to 15 carbon atoms. $R^{41}$ represents an alkylene group having from 1 to 100 carbon atoms, which may have a substituent. Examples of the substituent include an alkyl group having from 1 to 20 carbon atoms and an aromatic hydrocarbon group having from 6 to 15 carbon atoms. p represents an integer of 1 to 100.

In the definition of the formula (1), specific examples of "aromatic hydrocarbon group" include a phenyl group, a tolyl group, a naphthyl group, an anthryl group, a biphenyl group and a phenanthryl group, and specific examples of "heteroaromatic ring group" include a furyl group, a thionyl group, an oxazolyl group, an imidazolyl group, a pyranyl group, a pyridinyl group, an acridinyl group, a benzofuranyl group, a benzothionyl group, a benzopyranyl group, a benzoxazolyl group and a benzimidazolyl group.

Also, the moiety of $(R^{41}\text{-O})_p$ in the formula (I) may be two or three kinds of groups within the above-described scope. Specifically, there may be illustrated a random or block chain of a combination of ethyleneoxy group and propyleneoxy group, a combination of ethyleneoxy group and isopropyleneoxy group, a combination of ethyleneoxy group and butyleneoxy group, and a combination of ethyleneoxy group and isobutyleneoxy group. In the invention, the surfactants having polyoxyalkylene ether group are used independently or in combination. The surfactant is effectively added in an amount from 1 to 30% by weight, preferably from 2 to 20% by weight, in the developing solution. When the amount of the surfactant is from 1 to 30% by weight, deterioration of developing property, damage at the development, deterioration of printing durability of printing plate and the like are restrained.

Examples of the nonionic surfactant having polyoxyalkylene ether group represented by formula (I) include a polyoxyethylene alkyl ether, e.g., polyoxyethylene lauryl ether, polyoxyethylene cetyl ether and polyoxyethylene stearyl ether; a polyoxyethylene aryl ether, e.g., polyoxyethylene phenyl ether and polyoxyethylene naphthyl ether; and a polyoxyethylene alkylaryl ether, e.g., polyoxyethylene methylphenyl ether, polyoxyethylene octylphenyl ether and polyoxyethylene nonylphenyl ether.

The surfactants can be used independently or in combination thereof.

The pH of the developing solution used in the plate-making method according to the invention is preferably from 11.0 to 12.7, more preferably from 11.5 to 12.5. When the pH of the developing solution is in the range from 11.0 to 12.7, the image-formation is preferably conducted, over development is prevented, and the damage of the exposed area at the development is restrained.

The electric conductivity of the developing solution used in the invention is preferably from 3 to 30 mS/cm. When the electric conductivity of the developing solution is in the range from 3 to 30 mS/cm, a dissolution rate of the photosensitive layer on the surface of the aluminum plate support can be appropriately controlled, and formation of stain at printing due to residual film in the unexposed area is prevented. The electric conductivity is particularly preferably in the range from 5 to 20 mS/cm.

(Exposure and development processing)

An image can be formed on the surface of the aluminum plate support by imagewise exposing the photosensitive lithographic printing plate of the invention using a conventionally known active light source, for example, a carbon arc lamp, a high-pressure mercury lamp, a xenon lamp, a metal halide lamp, a fluorescent lamp, a tungsten lamp, a halogen lamp, a helium cadmium laser, an argon ion laser, an FD-YAG laser, a helium neon laser or a semiconductor laser (wavelength of 350 to 600 nm), followed by development processing. It is possible to provide, between the imagewise exposure and the development processing, a process of heating at a temperature of 50 to 140°C for 1 second to 5 minutes for the purpose of increasing the curing ratio of the photopolymerizable photosensitive layer. When the temperature for heating is in the above-described range, the effect of increasing the curing ratio is obtained and the occurrence of residual film due to dark polymerization in the unexposed area is also prevented.

As described hereinbefore, when an oxygen blocking protective layer is provided on the photosensitive layer of the photosensitive lithographic printing plate according to the invention, there have been known a method of removing both the oxygen blocking protective layer and the unexposed area of the photosensitive layer at the same time using the developing solution and a method of first removing the oxygen blocking protective layer with water or warm water, and then removing the unexposed area of the photosensitive layer with the developing solution. Into the water or warm water may be incorporated an antiseptic described in JP-A-10-10754 or an organic solvent described in JP-A-8-278636.

The development of the photosensitive lithographic printing plate of the invention with the above-described developing solution is conducted in a conventional manner at a temperature ordinarily from 0 to 60°C, preferably from 15 to 40°C, for example, by immersing the exposed photosensitive lithographic printing plate in the developing solution and rubbing with a brush.

Further, in the case of conducting the development processing using an automatic developing machine, the developing solution becomes fatigued in accordance with the processing amount, and hence the processing ability may be restored by using a replenishing solution or a fresh developing solution.

The thus development-processed photosensitive lithographic printing plate is after-treated with washing water, a rinsing solution containing a surfactant, or a desensitizing solution containing gum arabic or a starch derivative as described in JP-A-54-8002, JP-A-55-115045 and JP-A-59-58431. In the after-treatment of the photosensitive lithographic printing plate of the invention, these processings may be used in combination.

The lithographic printing plate thus-obtained by the above-described processing may be subjected to the after-exposing treatment described in JP-A-2000-89478 or a heating treatment, for example, baking to improve printing durability.

The lithographic printing plate obtained by the processing is mounted on an offset printing machine to perform printing of a large number of sheets.

## EXAMPLES

The present invention is described in more detail with reference to the following examples, but the invention should not be construed as being limited thereto.

### Example 1

(Preparation of aluminum support)

A 0.3 mm-thick aluminum plate was etched by dipping in a 10% by weight aqueous sodium hydroxide solution at 60°C for 25 seconds, washed with running water, neutralized and cleaned with a 20% by weight aqueous nitric acid solution and then washed with water. The aluminum plate was then subjected to an electrolytic surface roughening treatment in a 1 % by weight aqueous nitric acid solution using an alternating current with a sinusoidal waveform at an anode time electricity of 300 Coulomb/$dm^2$. Subsequently, the aluminum plate was dipped in a 1% by weight aqueous sodium hydroxide solution at 40°C for 5 seconds, dipped in a 30% by weight aqueous sulfuric acid solution at 60°C for 40 seconds to effect a desmut treatment, and then subjected to an anodizing treatment in a 20% by weight aqueous sulfuric acid solution for 2 minutes at a current density of 2 A/$dm^2$ to form an anodic oxide film having a thickness of 2.7 g/$m^2$. The surface roughness of the aluminum plate was measured and found to be 0.3 μm (Ra value according to JIS B 0601) .

(Coating of intermediate layer)

On the aluminum support thus-obtained was coated a coating solution for intermediate layer having the composition shown below using a wire bar, followed by drying using a hot air drying apparatus at 90°C for 30 seconds. A coating amount of the intermediate layer after drying was 10 mg/$m^2$.

<Coating Solution for Intermediate Layer>

| | |
|---|---|
| Copolymer of ethyl methacrylate and sodium 2-acrylamido-2-methyl-1-propanesulfonate (75:25 in a molar ratio) | 0.1 g |
| 2-Aminoethylphosphonic acid | 0.1 g |
| Methanol | 50 g |
| Ion-exchanged water | 50 g |

(Coating of photosensitive layer)

A coating solution for photosensitive layer having the composition shown below was prepared and coated on the intermediate layer so as to have a thickness after drying of 1. 4 g/$m^2$ by a wheeler followed by drying at 100°C for one minute.

<Coating Solution for Photosensitive Layer>

| | |
|---|---|
| Ethylenically unsaturated polymerizable compound: Compound represented by Formula 1 shown below | 1.5 g |
| Polymer compound: CompoundA-1 shown hereinbefore | 2.0 g |
| Sensitizing dye: Compound represented by Formula 2 shown below | 0.1 g |
| Photopolymerization initiator: Compound represented by Formula 3 shown below | 0.2 g |
| Co-sensitizer: Compound represented by Formula 4 shown below | 0.2 g |
| Colored pigment dispersion (having the composition shown below) | 2.0 g |
| Thermal polymerization inhibitor: N-nitrosophenylhydroxylamine aluminum salt | 0.01 g |
| Surfactant: Megafac F176, produced by Dainippon Ink & Chemicals, Inc. | 0.02 g |
| Methyl ethyl ketone | 20.0 g |
| Propylene glycol monomethyl ether | 20.0 g |

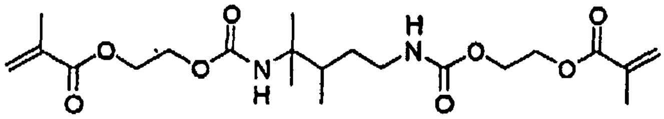

Formula 1

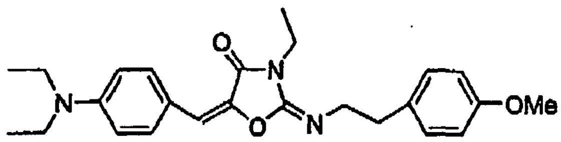

Formula 2

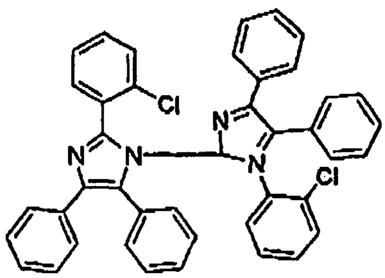

Formula 3

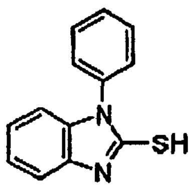

Formula 4

<Composition of Colored Pigment Dispersion>

| | |
|---|---|
| Pigment Blue 15:6 | 15 parts by weight |
| Copolymer of allyl methacrylate and methacrylic acid (copolymerization molar ratio: 83/17) | 10 parts by weight |
| Cyclohexanone | 15 parts by weight |

(continued)

| | |
|---|---|
| Methoxypropyl acetate | 20 parts by weight |
| Propylene glycol monomethyl ether | 40 parts by weight |

(Coating of oxygen blocking protective layer)

A 3% by weight aqueous solution of polyvinyl alcohol (saponification degree: 78% by mole, polymerization degree: 550) was coated on the photosensitive layer so as to have a dry coating amount of 2 $g/m^2$ and dried at 100°C for 2 minutes to form an oxygen blocking protective layer, thereby preparing a photosensitive lithographic printing plate.

Examples 2 to 10

Photosensitive lithographic printing plates were prepared in the same manner as in Example 1 except for changing the polymer compound in the coating solution for photosensitive layer of Example 1 to polymer compounds shown in Table 1 below, respectively.

**TABLE 1**

| Example | Polymer Compound |
|---|---|
| 2 | Compound A-2 shown hereinbefore |
| 3 | Compound A-3 shown hereinbefore |
| 4 | Compound A-4 shown hereinbefore |
| 5 | Compound A-9 shown hereinbefore |
| 6 | Compound A-10 shown hereinbefore |
| 7 | Compound A-5 shown hereinbefore |
| 8 | Compound A-6 shown hereinbefore |
| 9 | Compound A-7 shown hereinbefore |
| 10 | Compound A-12 shown hereinbefore |

Examples 11 to 16

Photosensitive lithographic printing plates were prepared in the same manner as in Example 1 except for changing the ethylenically unsaturated polymerizable compound, sensitizing dye, photopolymerization initiator and co-sensitizer in the coating solution for photosensitive layer of Example 1 to compounds shown in Table 2 below, respectively.

Table 2

| Example | Ethylenically Unsaturated Polymerizable Compound | Sensitizing Dye | Photopolymerization Initiator | Co-sensitizer |
|---|---|---|---|---|
| 11 | Pentaerythritol tetraacrylate | 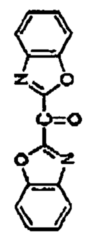 | 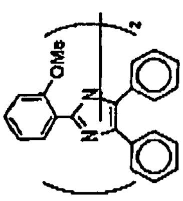 | 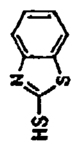 |
| 12 | 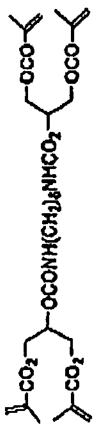 | 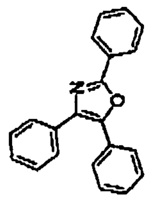 | 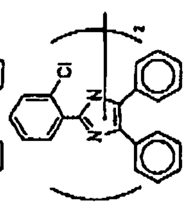 | 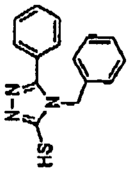 |
| 13 | 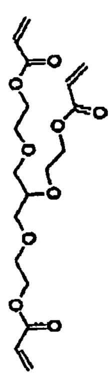 | 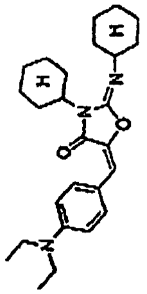 | 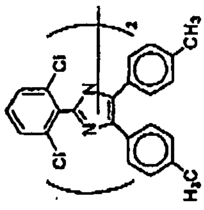 | 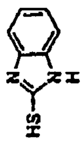 |
| 14 | Trimethylolpropane trimethacrylate | 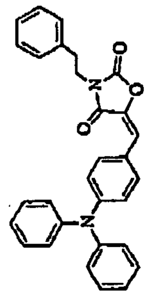 | 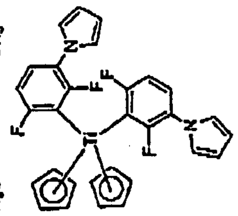 | 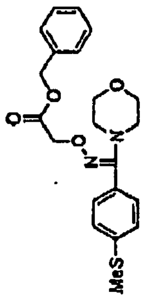 |
| 15 | 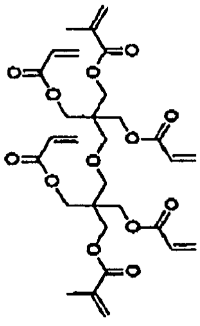 | 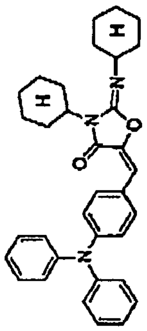 | 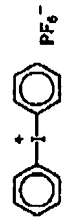 | 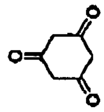 |
| 16 | 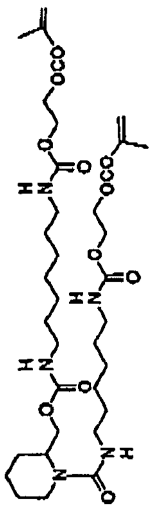 | 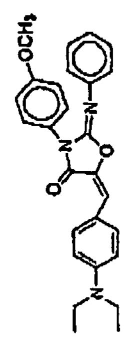 | 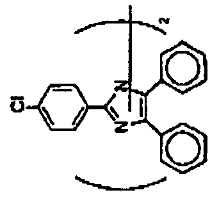 | 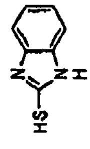 |

Example 17

A photosensitive lithographic printing plate was prepared in the same manner as in Example 1 except for

changing the aluminum support to an aluminum support shown below.

(Preparation of aluminum support)

An aluminum plate of JIS A 1050 having a thickness of 0.24 mm and a width of 1030 mm was continuously subjected to the following surface treatments.

(a) Mechanical surface roughening treatment of the aluminum plate was conducted by means of rotating roller-form nylon brushes while supplying a suspension of an abrasive (pumice) in water having specific gravity of 1.12 as an abrasion slurry solution to the surface of the aluminum plate using an existing mechanical surface roughening apparatus. An average particle size of the abrasive was from 40 to 45 μm, with the maximum particle size being 200 μm. A material of the nylon brush was 6.10 nylon, and the brush has a bristle length of 50 mm and a bristle diameter of 0.3 mm. The nylon brush was made by making holes in a stainless steel cylinder having a diameter of 300 mm and densely filling the brush bristles. Three of the rotating nylon brushes were used. Two supporting rollers (each having a diameter of 200 mm) provided under the brush rollers were spaced 300 mm. The brush rollers were pressed against the aluminum plate till the load applied to a driving motor for rotating the brush became 7 kw greater than the load before pressing the brush rollers against the aluminum plate. The rotating direction of the brushes was the same as the moving direction of the aluminum plate. The rotation number of the brushes was 200 rpm.
(b) Etching treatment of the aluminum plate was conducted by spraying an aqueous solution having a sodium hydroxide concentration of 2.6% by weight, an aluminum ion concentration of 6.5% by weight and temperature of 70°C to dissolve the aluminum plate in an amount of 0.3 g/m$^2$, followed by washing with water by spraying.
(c) Desmut treatment of the aluminum plate was conducted by spraying an aqueous solution having temperature of 30°C and a nitric acid concentration of 1% by weight (containing 0.5% by weight of aluminum ion), followed by washing with water by spraying. The aqueous nitric acid solution used for the desmut treatment was a waste solution from the step of conducting electrochemical surface roughening treatment in an aqueous nitric acid solution using alternating current described below.
(d) Electrochemical surface roughening treatment of the aluminum plate was continuously conducted by applying 60 Hz alternating current voltage. The electrolytic solution used was an aqueous solution containing 1% by weight of nitric acid (containing 0. 5% by weight of aluminum ion and 0.007% by weight of ammonium ion) and having solution temperature of 40°C. The electrochemical surface roughening treatment was conducted using an alternating current source, which provided a trapezoidal rectangular wave alternating current where time (TP) for reaching the current to its peak from zero was 2 msec and a duty ratio was 1:1, and using a carbon electrode as a counter electrode. A ferrite was used as an auxiliary anode. The current density was 30 A/dm$^2$ at the peak current, and the electric amount was 255 Coulomb/dm$^2$ in terms of the total electric quantity during the aluminum plate functioning as an anode. To the auxiliary anode, 5% of the current from the electric source was divided. Subsequently, the plate was washed with water by spraying.
(e) Etching treatment of the aluminum plate was conducted at 32°C by spraying an aqueous solution having a sodium hydroxide concentration of 26% by weight and an aluminum ion concentration of 6.5% by weight to dissolve the aluminum plate in an amount of 0.2 g/m$^2$. Thus, the smut component mainly comprising aluminum hydroxide formed in the precedent electrochemical surface roughening treatment using alternating current was removed and an edge portion of the pit was dissolved away to smoothen the edge portion. Subsequently, the plate was washed with water by spraying.
(f) Desmut treatment of the aluminum plate was conducted by spraying an aqueous solution having temperature of 60°C and nitric acid concentration of 25% by weight (containing 0.5% by weight of aluminum ion), followed by washing with water by spraying.
(g) Anodizing treatment of the aluminum plate was conducted using an existing anodizing treatment apparatus according to a two-stage feeding electrolytic treatment method (lengths of a first electrolytic unit and a second electrolytic unit: 6 m each; length of a first feeding unit: 3 m; length of a second feeding unit: 3 m; lengths of a first feeding electrode and a second feeding electrode: 2.4 m each) with an electrolytic solution having sulfuric acid concentration of 170 g/liter (containing 0.5% by weight of aluminum ion) in the electrolytic unit at temperature of 38°C. Subsequently, the plate was washed with water by spraying. In the anodizing treatment apparatus, an electric current flowed from a power source to the first feeding electrode provided in the first feeding unit, then to the aluminum plate through the electrolytic solution to form an anodic oxide film on the surface of the aluminum plate in the first feeding unit, and returned to the power source through an electrolytic electrode provided in the first feeding unit. On the other hand, the electric current from the power source also flowed to the second feeding electrode provided in the second feeding unit, then to the aluminum plate through the electrolytic solution to form an anodic oxide film on the surface of the aluminum plate in the second feeding unit. The electric quantity fed from the power source to the first feeding unit was same as that fed from the power source to the second feeding unit, and the feeding current

density on the surface of the anodic oxide film was about 25 A/$dm^2$ in the second feeding unit. In the second feeding unit, the current was fed from the surface of the anodic oxide film of 1. 35 g/$m^2$. The final anodic oxide film amount was 2.7 g/$m^2$.

## Comparative Examples 1 to 3

Photosensitive lithographic printing plates were prepared in the same manner as in Example 1 except for changing the polymer compound in the coating solution for photosensitive layer of Example 1 to polymer compounds shown in Table 3 below, respectively.

Table 3

| Comparative Example | Polymer Compound | Acid Value | Molecular Weight (Mw) |
|---|---|---|---|
| 1 | 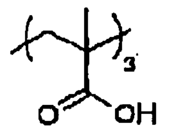 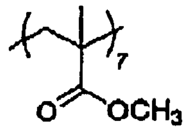 | 1.9 | 50,000 |
| 2 | 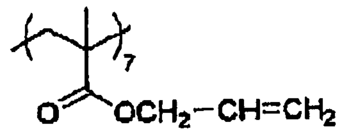 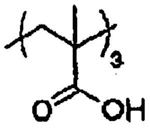 | 1.9 | 60,000 |
| 3 | 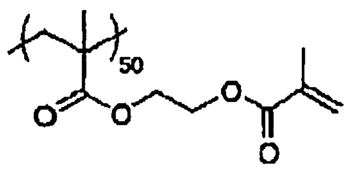 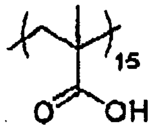 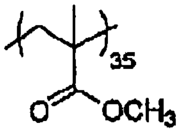 | 1.2 | 34,000 |

The photosensitive lithographic printing plates of Examples 1 to 17 and Comparative Examples 1 to 3 were exposed and subjected to development/plate-making to evaluate with respect to sensitivity, halftone dot uniformity and time-lapse stability in the following manner.

(Sensitivity)

The photosensitive lithographic printing plate was stored at a room temperature (about 25°C) for 3 days, and after attaching a gray scale prepared so as to change an exposure amount by $1/\sqrt{2}$ on the surface of the photosensitive lithographic printing plate, it was subjected to overall exposure using a plate setter (Vx9600CTP, produced by FUJIFILM Electronic Imaging, Ltd.) equipped with a violet laser of 30 mW while controlling an exposure amount on the surface of photosensitive lithographic printing plate to 0.1 mJ/$cm^2$. Then, the photosensitive lithographic printing plate was subjected to development/plate-making as shown below. As the step number of the gray scale reproduced on the lithographic printing plate is larger, the sensitivity is higher.

(Halftone Dot Uniformity)

The photosensitive lithographic printing plate was stored at a room temperature (about 25°C) for 3 days, and then a 50% halftone dot image of 200 lines was drawn on the whole surface of photosensitive lithographic printing plate using a plate setter (Vx9600CTP, produced by FUJIFILM Electronic Imaging, Ltd.) equipped with a violet laser of 30 mW while controlling an exposure amount on the surface of photosensitive lithographic printing plate to 0.1 mJ/$cm^2$. Then, the photosensitive lithographic printing plate was subjected to development/plate-making as shown below. The halftone dot areas at 9 points on the surface of lithographic printing plate were measured, and an average value of the halftone dot area and a difference between the maximum value and the minimum value of the halftone dot areas were determined. As the average value of the halftone dot area is larger, the sensitivity is higher. As the difference between the maximum value and the minimum value of the halftone dot areas is smaller, the halftone dot uniformity is better.

(Time-Lapse Stability)

The photosensitive lithographic printing plate was stored in a thermo-cell chamber at 60°C for 3 days, and then subjected to the exposure and development/plate-making in the same manner as described above to evaluate the sensitivity and halftone dot uniformity. The results were compared with those obtained from the photosensitive lithographic printing plate which had been stored at 25°C for 3 days (Fr) to determine differences. As the differences are small, the time-lapse stability is high.

(Development/Plate-Making)

The exposed photosensitive lithographic printing plate was subjected to development/plate-making using an automatic developing machine (LP-850P2, produced by Fuji Photo Film Co., Ltd.) set a preheating temperature at 100°C and fed with a developing solution having the composition shown below and a finisher (FP-2W, produced by Fuji Photo Film Co., Ltd.) under conditions of a developing temperature of 30°C and developing time of 18 seconds to prepare a lithographic printing plate.

<Developing Solution (pH: 11.6) >

| | |
|---|---|
| Sodium hydroxide | 0.15 parts by weight |
| Compound (a) shown below | 5.0 parts by weight |
| Ethylenediaminetetraacetate·4N a salt | 0.1 part by weight |
| Water | 94.75 parts by weight |

(a)

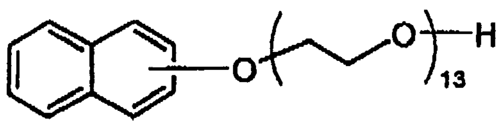

The results are shown in Table 4 below.

**TABLE 4**

| | Fr | | | After Storage at 60°C for 3 Days | | |
|---|---|---|---|---|---|---|
| | Sensitivity G/S | 50% Halftone dot (%) | | Sensitivity G/S | 50% Halftone dot (%) | |
| | | Average value | Maximum value - Minimum Value | | Average value | Maximum value - Minimum Value |
| Example 1 | 5.5 | 76.3 | 1.0 | 5.7 | 76.5 | 1.0 |
| Example 2 | 5.0 | 75.0 | 1.0 | 5.0 | 76.0 | 1.0 |
| Example 3 | 5.8 | 77.5 | 1.5 | 6.0 | 77.0 | 1.5 |
| Example 4 | 5.8 | 77.3 | 1.0 | 5.8 | 77.5 | 1.5 |
| Example 5 | 6.3 | 79.3 | 2.0 | 6.0 | 78.5 | 2.0 |
| Example 6 | 5.3 | 77.1 | 1.5 | 5.0 | 76.0 | 1.5 |
| Example 7 | 6.0 | 79.2 | 1.0 | 6.3 | 78.5 | 1.5 |
| Example 8 | 5.3 | 76.3 | 1.5 | 5.0 | 76.0 | 1.5 |
| Example 9 | 5.0 | 75.0 | 1.5 | 5.0 | 75.0 | 1.0 |
| Example 10 | 5.8 | 76.5 | 2.0 | 5.3 | 76.0 | 2.0 |
| Example 11 | 5.7 | 73.5 | 1.5 | 5.7 | 73.0 | 1.5 |
| Example 12 | 5.5 | 74.0 | 1.5 | 5.7 | 74.5 | 2.0 |
| Example 13 | 5.0 | 73.0 | 1.0 | 5.0 | 74.5 | 1.0 |
| Example 14 | 5.8 | 76.8 | 1.5 | 5.8 | 76.5 | 1.5 |
| Example 15 | 5.7 | 73.0 | 1.5 | 5.7 | 73.0 | 1.5 |
| Example 16 | 5.0 | 74.0 | 1.5 | 5.0 | 74.5 | 1.0 |
| Example 17 | 5.5 | 75.0 | 1.5 | 5.7 | 75.0 | 1.5 |
| Comparative Example 1 | 3.0 | 58.2 | 5.0 | 2.0 | 53.2 | 4.0 |
| Comparative Example 2 | 5.0 | 75.3 | 3.0 | 3.5 | 63.3 | 3.0 |
| Comparative Example 3 | 6.8 | 76.9 | 7.5 | 10.8 | 92.0 | 10.5 |

From the results shown in Table 4, it can be seen that Examples 1 to 17 exhibit high sensitivity and are excellent in the halftone dot uniformity and time-lapse stability in comparison with Comparison Examples 1 to 3.

Example 21

The preparation of aluminum support and coating of intermediate layer were conducted in the same manner as in Example 1.

(Coating of photosensitive layer)

A coating solution for photosensitive layer having the composition shown below was prepared and coated on the intermediate layer so as to have a thickness after drying of 1.5 g/$m^2$ by a wheeler followed by drying at 100°C for one minute.

<Coating Solution for Photosensitive Layer>

| | |
|---|---|
| Ethylenically unsaturated polymerizable compound: Compound represented by Formula 1 shown below | 1.5 g |
| Polymer compound: Compound represented by Formula 2 shown below (molecular weight (Mw): 5.3 x $10^4$ ; acid value: 1.1; C=C amount: 1.9 mmol) | 2.0 g |
| Sensitizing dye: Compound represented by Formula 3 shown below | 0.1 g |
| Photopolymerization initiator: Compound represented by Formula 4 shown below | 0.2 g |
| Co-sensitizer: Compound represented by Formula 5 shown below | 0.2 g |
| Colored pigment dispersion (having the composition shown below) | 2.0 g |
| Thermal polymerization inhibitor: N-nitrosophenylhydroxylamine aluminum salt | 0.01 g |
| Surfactant: Megafac F176, produced by Dainippon Ink & Chemicals, Inc. | 0.02 g |
| Methyl ethyl ketone | 20.0 g |
| Propylene glycol monomethyl other | 20.0 g |

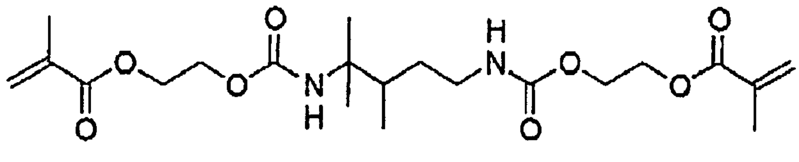

Formula 1

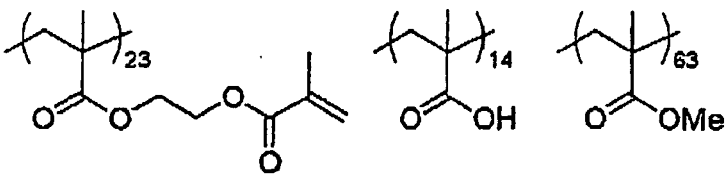

Formula 2

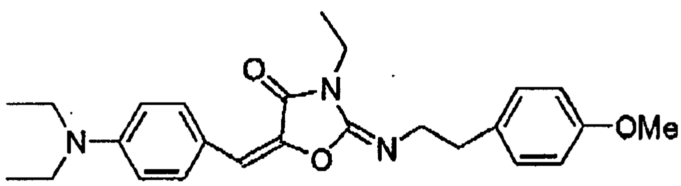

Formula 3

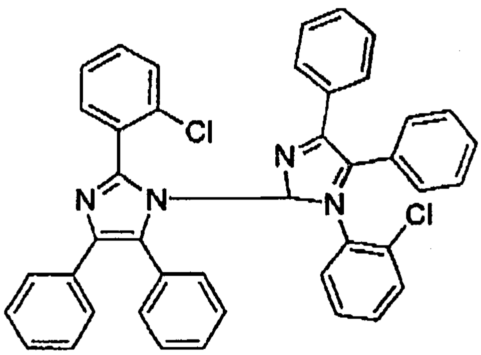

Formula 4

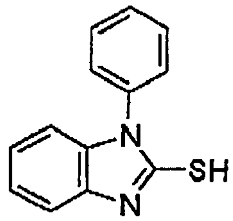

Formula 5

<Composition of Colored Pigment Dispersion>

| | |
|---|---|
| Pigment Blue 15:6 | 15 parts by weight |
| Copolymer of allyl methacrylate and methacrylic acid (copolymerization molar ratio: 83/17) | 10 parts by weight |
| Cyclohexanone | 15 parts by weight |
| Methoxypropyl acetate | 20 parts by weight , |
| Propylene glycol monomethyl ether | 40 parts by weight |

(Coating of oxygen blocking protective layer)

A 3% by weight aqueous solution of polyvinyl alcohol (saponification degree: 98% by mole, polymerization degree: 550) was coated on the photosensitive layer so as to have a dry coating amount of 2 g/$m^2$ and dried at 100°C for 2 minutes to form an oxygen blocking protective layer, thereby preparing a photosensitive lithographic printing plate.

Examples 22 to 30

Photosensitive lithographic printing plates were prepared in the same manner as in Example 21 except for changing the polymer compound in the coating solution for photosensitive layer of Example 21 to polymer compounds shown in Table 5 below, respectively.

**TABLE 5**

| Example | Polymer Compound | Molecular Weight (x $10^4$) | C=C Amount (mmol/g) | Acid Value |
|---|---|---|---|---|
| 22 | 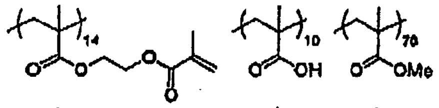 | 4.5 | 1.2 | 1.1 |
| 23 | 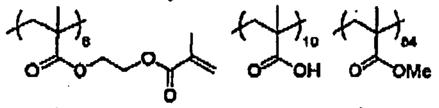 | 3.8 | 0.6 | 0.9 |
| 24 | 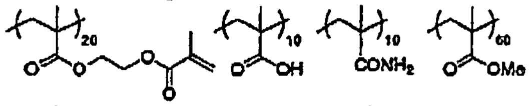 | 6.0 | 1.8 | 1.0 |
| 25 | 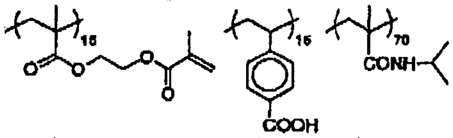 | 5.3 | 1.0 | 1.2 |
| 26 | 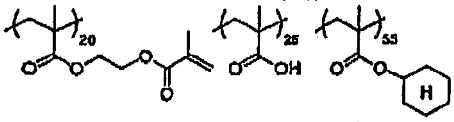 | 3.2 | 1.2 | 1.9 |
| 27 | 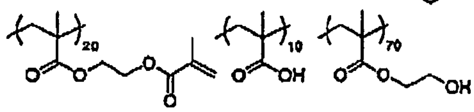 | 7.8 | 1.2 | 0.9 |
| 28 | 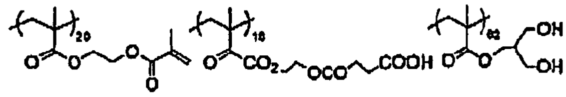 | 3.0 | 1.2 | 1.5 |
| 29 | 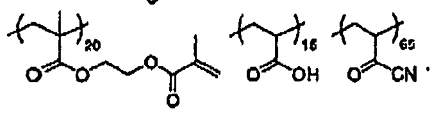 | 4.8 | 1.3 | 1.2 |
| 30 | 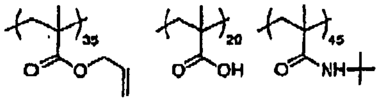 | 2.1 | 2.6 | 1.6 |

**Examples 31 to 36**

Photosensitive lithographic printing plates were prepared in the same manner as in Example 21 except for changing the ethylenically unsaturated polymerizable compound, sensitizing dye, photopolymerization initiator and co-sensitizer in the coating solution for photosensitive layer of Example 21 to compounds shown in Table 6 below, respectively.

**TABLE 6**

| Example | Ethylenically Unsaturated Polymerizable Compound | Sensitizing Dye | Photopolymerization Initiator | Co-sensitizer |
|---|---|---|---|---|
| 31 | Pentaerythritol tetraacrylate | 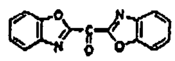 | 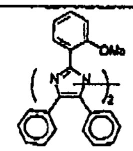 | 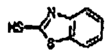 |
| 32 | 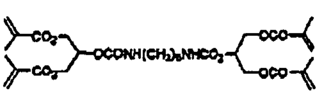 | 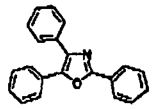 | 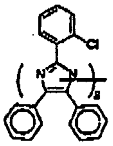 | 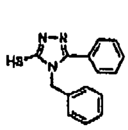 |
| 33 | 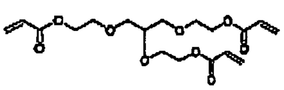 | 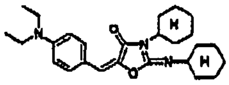 | 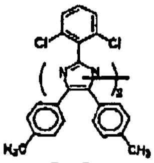 | 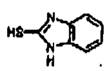 |
| 34 | Trimethylolpropane trimethacrylate | 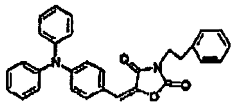 | 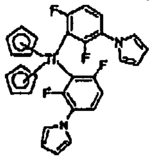 | 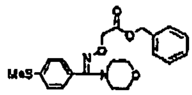 |
| 35 | 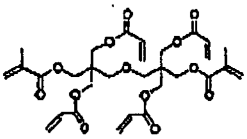 | 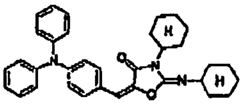 | 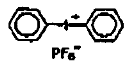 | 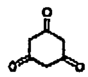 |
| 36 | 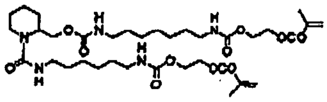 | 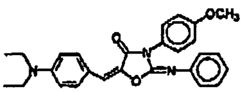 | 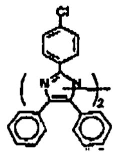 | 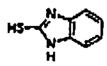 |

## Example 37

A photosensitive lithographic printing plate was prepared in the same manner as in Example 21 except for changing the aluminum support used in Example 21 to the aluminum support used in Example 17.

## Example 38

A photosensitive lithographic printing plate was prepared in the same manner as in Example 21 except for changing the intermediate layer used in Example 21 to an intermediate layer shown below.

(Coating of intermediate layer)

The sol solution composition for intermediate layer shown below was charged in a beaker and stirred at 25°C

for 20 minutes.

<Sol Solution Composition for Intermediate Layer>

| | |
|---|---|
| Tetraethoxysilane | 38 g |
| 3-Methacryloxypropyltrimethoxysilane | 13 g |
| 85% aqueous phosphoric acid solution | 12 g |
| Ion exchanged water | 15 g |
| Methanol | 100 g |

The solution of the above composition was put into a three-necked flask, a reflux condenser was loaded on the three-necked flask, and the three-necked flask was immersed in an oil bath of a room temperature. The temperature of the content of the three-necked flask was raised to 50°C for 30 minutes while stirring with a magnetic stirrer. The content was further reacted for one hour while maintaining the temperature of oil bath at 50°C to obtain a sol solution. The sol solution thus obtained was diluted with a mixture of methanol and ethylene glycol (20/1 by weight) to a concentration of 0.5% by weight, coated on the above-described aluminum plate by a wheeler, and then dried at 100°C for 1 minute. The coating amount of the sol solution was 3.5 mg/$m^2$. The coating amount was a value obtained according to determination of an amount of Si element by a fluorescent x-ray analysis method.

Comparative Examples 4 to 7

Photosensitive lithographic printing plates were prepared in the same manner as in Example 21 except for changing the polymer compound in the coating solution for photosensitive layer of Example 21 to polymer compounds shown in Table 7 below, respectively.

TABLE 7

| Comparative Example | Polymer Compound | Molecular Weight ($\times 10^4$) | C=C Amount (mmol/g) | Acid Value |
|---|---|---|---|---|
| 4 | 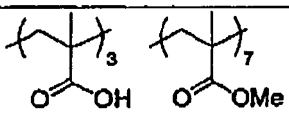 | 5 | 0 | 1.9 |
| 5 | 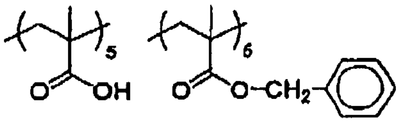 | 3 | 0 | 3.8 |
| 6 | 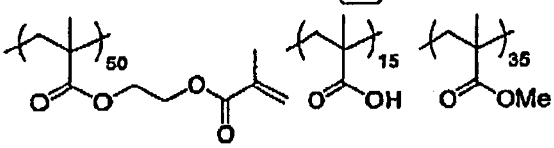 | 4 | 3.4 | 1.2 |
| 7 | 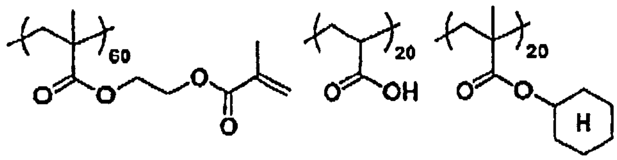 | 2.7 | 4.2 | 1.9 |

Using the photosensitive lithographic printing plates of Examples 21 to 38 and Comparative Examples of 4 to 7, the evaluations of the sensitivity and halftone dot uniformity were conducted in the same manner as in Example 1 to 17 and Comparison Example 1 to 3 described above. Also, using the photosensitive lithographic printing plates stored in a thermo-cell chamber at 60°C for 3 days, the evaluation of the time-lapse stability was conducted in the same manner as in Example 1 to 17 and Comparison Example 1 to 3 described above.

The results are shown in Table 8 below.

TABLE 8

| | Fr | | | After Storage at 60°C for 3 Days | | |
|---|---|---|---|---|---|---|
| | Sensitivity G/S | 50% Halftone dot (%) | | Sensitivity G/S | 50% Halftone dot (%) | |
| | | Average value | Maximum value - Minimum Value | | Average value | Maximum value - Minimum Value |
| Example 21 | 5.8 | 77.3 | 1.0 | 6.0 | 77.9 | 1.0 |
| Example 22 | 5.5 | 76.3 | 1.0 | 5.7 | 76.5 | 1.0 |
| Example 23 | 5.0 | 75.0 | 1.5 | 5.0 | 76.0 | 1.5 |
| Example 24 | 5.3 | 76.2 | 1.5 | 5.5 | 76.5 | 2.0 |
| Example 25 | 5.8 | 77.0 | 1.0 | 6.0 | 77.0 | 1.5 |
| Example 26 | 6.0 | 79.0 | 1.5 | 6.3 | 78.5 | 2.0 |
| Example 27 | 5.3 | 76.4 | 2.0 | 5.3 | 76.0 | 1.5 |
| Example 28 | 5.3 | 76.1 | 1.5 | 5.0 | 76.0 | 1.5 |
| Example 29 | 6.2 | 79.3 | 1.5 | 6.0 | 78.3 | 1.0 |
| Example 30 | 5.7 | 73.2 | 1.5 | 5.7 | 73.0 | 1.5 |
| Example 31 | 5.7 | 73.0 | 1.0 | 6.0 | 73.0 | 1.5 |
| Example 32 | 5.5 | 74.0 | 1.5 | 5.7 | 74.5 | 2.0 |
| Example 33 | 5.0 | 75.0 | 1.5 | 5.0 | 75.0 | 1.0 |
| Example 34 | 5.5 | 76.0 | 1.5 | 5.5 | 75.5 | 2.0 |
| Example 35 | 5.8 | 76.8 | 1.0 | 5.8 | 76.5 | 1.5 |
| Example 36 | 6.3 | 79.3 | 2.0 | 6.3 | 78.8 | 2.5 |
| Example 37 | 5.8 | 76.5 | 2.0 | 5.5 | 76.5 | 2.0 |
| Example 38 | 5.3 | 76.3 | 1.5 | 5.5 | 76.6 | 1.5 |
| Comparative Example 4 | 3.0 | 58.2 | 5.0 | 2.0 | 53.2 | 4.0 |
| Comparative Example 5 | 3.3 | 58.5 | 3.0 | 2.0 | 53.5 | 3.0 |
| Comparative Example 6 | 6.8 | 76.9 | 7.5 | 10.8 | 92.0 | 10.5 |
| Comparative Example 7 | 3.8 | 59.0 | 8.0 | 7.8 | 88.0 | 9.5 |

From the results shown in Table 8, it can be seen that Examples 21 to 38 exhibit high sensitivity and are

excellent in the halftone dot uniformity and time-lapse stability in comparison with Comparison Examples 4 to 7.

This application is based on Japanese Patent application JP 2005-14242, filed January 21, 2005, and Japanese Patent application JP 2005-91778, filed March 28, 2005, the entire contents of which are hereby incorporated by reference, the same as if set forth at length.

## Claims

1. A photosensitive lithographic printing plate comprising an aluminum support and a photopolymerizable photosensitive layer containing a polymer compound including

    (i) a structure unit having a carbon-carbon double bond in a side chain, (ii) a structure unit having an acid group, and (iii) at least one structure unit selected from the following structure units (a) to (c) :

        (a) a structure unit having an ethyleneoxy group,
        (b) a structure unit having a cyclohexyl group, and
        (c) a structure unit having two or more hydroxy groups.

2. The photosensitive lithographic printing plate as claimed in claim 1, wherein the polymer compound has the carbon-carbon double bond in an amount of from 0.2 to 2.3 mmol per g of the polymer compound and an acid value of from 0.5 to 2.0.

3. The photosensitive lithographic printing plate as claimed in claim 2, wherein the polymer compound has the carbon-carbon double bond in an amount of from 0.7 to 1.5 mmol per g of the polymer compound.

4. The photosensitive lithographic printing plate as claimed in any one of claims 1 to 3, wherein the photopolymerizable photosensitive layer further contains a photopolymerization initiator and an ethylenically unsaturated polymerizable compound.

5. The photosensitive lithographic printing plate as claimed in claim 4, wherein the photopolymerization initiator is a hexaarylbisimidazole compound.

6. The photosensitive lithographic printing plate as claimed in any one of claims 1 to 5, which further comprises an oxygen blocking protective layer provided on the photopolymerizable photosensitive layer.

7. The photosensitive lithographic printing plate as claimed in claim 6, wherein the oxygen blocking protective layer contains a water-soluble vinyl polymer